# EUROPEAN PATENT APPLICATION

(11) **EP 4 827 276 A1**
(43) Date of publication of application: **21.10.2026**
(21) Application number: 25203279.2
(22) Date of filing: 19.09.2025
(51) Int. Cl.: H10F 10/165, H10F 10/166, H10F 71/00, H10F 77/20

(54) **BACK-CONTACT SOLAR CELL AND METHOD FOR PREPARING THE SAME, AND BACK-CONTACT SOLAR MODULE**

(30) Priority: 15.04.2025 CN 202510471574
(71) Applicant: Tongwei Solar (Chengdu) Co., Ltd., Chengdu, Sichuan 610299 (CN)
(72) Inventor: TANG, Ping, Sichuan 610299 (CN); PAN, Shunmin, Sichuan 610299 (CN); CHEN, Xianzhi, Sichuan 610299 (CN); DENG, Mingzhang, Sichuan 610299 (CN); MENG, Xiajie, Sichuan 610299 (CN)
(74) Representative: Zacco Denmark A/S

(57) **Abstract**

A back-contact solar cell includes a silicon substrate, a first doped silicon layer, a second doped silicon layer, and a conductive block. The first doped silicon layer and the second doped silicon layer are provided on a back side of the silicon substrate, having opposite doping types and being separated by an isolation region. The conductive block is provided on the back side of the silicon substrate, partially located on the first doped silicon layer and partially located in the isolation region. The conductive block includes a third doped silicon layer having a same doping type as the second doped silicon layer and the silicon substrate. The first doped silicon layer and the third doped silicon layer are in electrical contact via an isolation buffer layer.

## Description

### TECHNICAL FIELD

The present invention relates to the field of solar technology, and in particular to a back-contact solar cell and a method for preparing the same, and a back-contact solar module.

### BACKGROUND

Back-contact solar cell is a type of high-efficiency solar cells in which the positive and negative electrodes are concentrated on the backlight side of the solar cell. During the manufacture of back-contact solar cells, in order to prevent recombination between two differently doped regions due to contact, isolation is required between the two to reduce recombination of carriers, ultimately achieving improved efficiency of the back-contact solar cell.

However, at the solar module end, after the back-contact solar cells are connected in series and in parallel, when one or more cells are blocked, they shall act like a load and not only will not generate electricity, but will consume the power of the solar module. During this process, the cell or its local area shall continue to heat up, eventually forming a hot spot.

In order to reduce the risk of hot spots in back-contact solar modules, the current conventional practice is to add a bypass diode adjacent to the cell string. The bypass diode can shield the cell string that produces the hot spot effect, thereby reducing the risk of hot spots, but it will greatly reduce the power output of the back-contact solar module.

Therefore, there is room for improvement for conventional back-contact solar cells.

### SUMMARY

Accordingly, a back-contact solar cell and a method for preparing the same, and a back-contact solar module are provided according to some embodiments of the present invention. The back-contact solar cell is beneficial to reducing the risk of hot spots in the back-contact solar module and improving the efficiency of the back-contact solar module.

According to a first aspect of the present invention, a back-contact solar cell is provided, including a silicon substrate; a first doped silicon layer and a second doped silicon layer that are provided on a back side of the silicon substrate, the first doped silicon layer and the second doped silicon layer having opposite doping types and being separated by an isolation region; and a conductive block provided on the back side of the silicon substrate, partially located on the first doped silicon layer and partially located in the isolation region; the conductive block including a third doped silicon layer having a same doping type as the second doped silicon layer and the silicon substrate; wherein the first doped silicon layer and the third doped silicon layer are in electrical contact via an isolation buffer layer, and a doping concentration of a doping element in the third doped silicon layer is greater than a doping concentration of a doping element in the silicon substrate.

According to the aforementioned back-contact solar cell, there is no conduction among the third doped silicon layer, the silicon substrate, and the second doped silicon layer in normal operation. When reverse bias is generated due to abnormal operation such as cell shading, current can be formed through drift motion, enabling the third doped silicon layer, the silicon substrate, and the second doped silicon layer to form a current channel, thereby effectively reducing the risk of hot spots in the back-contact solar cell.

In addition, by providing a part of the conductive block on the first doped silicon layer and a part in the isolation region, compared with the instance where the conductive block is entirely provided on the first doped silicon layer, a balance can be achieved between the conductive contact area representing the positive current flowing to the first doped silicon layer and conductive contact area representing the negative current flowing to the third doped silicon layer, thereby achieving the maximum annihilation efficiency between the positive photogenerated holes and the negative photogenerated electrons, being beneficial to improving the anti-hot-spot effect of the back-contact solar module when reverse bias occurs.

In any embodiment, along a thickness direction of the silicon substrate, a ratio of an orthographic projection area of a portion of the conductive block located on the first doped silicon layer to an orthographic projection area of a portion of the conductive block located in the isolation region is in a range of 0.1 to 10.

In any embodiment, the doping concentration of the doping element in the third doped silicon layer is in a range of 1 × 10¹⁹/cm³ to 1 × 10²¹/cm³.

In any embodiment, the doping concentration of the doping element in the silicon substrate is in a range of 1×10¹³/cm³ to 1×10¹⁶/cm³.

In any embodiment, a thickness of the third doped silicon layer is in a range of 10 nm to 400 nm.

In any embodiment, a spacing between the conductive block and the second doped silicon layer is in a range of 10 µm to 300 µm.

In any embodiment, along the thickness direction of the silicon substrate, an orthographic projection area of the conductive block is in a range of 1×10²µm² to 1×10⁵µm².

In any embodiment, a plurality of conductive blocks are provided, and along the thickness direction of the silicon substrate, a sum of orthographic projection areas of the plurality of conductive blocks accounts for 0.01% to 1.8% of an orthographic projection area of the silicon substrate.

In any embodiment, thicknesses of the first doped silicon layer and the second doped silicon layer are independently in a range of 10 nm to 400 nm.

In any embodiment, a ratio of a doping concentration of a doping element in the first doped silicon layer to a doping concentration of a doping element in the second doped silicon layer is in a range of 6% to 70%.

In any embodiment, the back-contact solar cell further includes a first tunneling layer located between the first doped silicon layer and the silicon substrate.

In any embodiment, the back-contact solar cell further includes a second tunneling layer located between the second doped silicon layer and the silicon substrate.

In any embodiment, the conductive block further includes a third tunneling layer provided in the isolation region and located between the silicon substrate and the third doped silicon layer.

In any embodiment, the isolation buffer layer is provided on a side of the first doped silicon layer away from the silicon substrate, and is located between the third doped silicon layer and the first doped silicon layer; and the isolation buffer layer is made of silicon oxide doped with at least one of boron and phosphorus.

According to a second aspect of the present invention, a method for preparing a back-contact solar cell is provided, including:
forming a first doped silicon layer, a second doped silicon layer, and a conductive block on a back side of a silicon substrate;
wherein the first doped silicon layer and the second doped silicon layer have opposite doping types and are separated by an isolation region; the conductive block is partially located on the first doped silicon layer and partially located in the isolation region; the conductive block includes a third doped silicon layer having a same doping type as the second doped silicon layer and the silicon substrate; the first doped silicon layer and the third doped silicon layer are in electrical contact via an isolation buffer layer; and a doping concentration of a doping element in the third doped silicon layer is greater than a doping concentration of a doping element in the silicon substrate.

In any embodiment, forming the first doped silicon layer on the back side of the silicon substrate includes:
forming a first doped silicon material layer on the back side of the silicon substrate; and
removing the first doped silicon material layer within the second doped silicon layer, the isolation region, and the conductive block, and serving the first doped silicon material layer retained on the back side of the silicon substrate as the first doped silicon layer.

In any embodiment, forming the second doped silicon layer and the conductive block on the back side of the silicon substrate includes:
forming a second doped silicon material layer on the back side of the silicon substrate after forming the first doped silicon layer; and
removing the second doped silicon material layer outside the second doped silicon layer and the conductive block, and serving the retained second doped silicon material layer as the second doped silicon layer and the third doped silicon layer.

According to a third aspect of the present invention, a back-contact solar module is provided, including the back-contact solar cell according to the first aspect of the present invention.

### BRIEF DESCRIPTION OF THE DRAWINGS

To better describe and illustrate embodiments or examples provided in the present invention, reference may be made to one or more accompanying drawings. The additional details or examples used to describe the accompanying drawings are not to be construed as limiting the scope of any one of the disclosed disclosure, the presently described embodiments or examples, and the presently understood preferred mode of the disclosure. In addition, the same reference numerals are used to represent the same components throughout the accompanying drawings. In the accompanying drawings:
FIG. 1 is a schematic view of a back-contact solar cell according to an embodiment of the present invention.
FIG. 2 is a photograph showing the location of the conductive block in a back-contact solar cell according to an embodiment of the present invention.
FIG. 3 is a schematic view of the structure after a first tunneling material layer, a first doped silicon material layer, and a first doped silicon oxide layer are prepared on the back side of the silicon substrate.
FIG. 4 is a schematic view of the structure after the first doped silicon oxide layer, the first doped silicon material layer, and the first tunneling material layer within the second doped silicon layer, the isolation region, and the conductive block in FIG. 3, as well as a part of the silicon substrate material are removed.
FIG. 5 is a schematic view of the structure after a second tunneling material layer, a second doped silicon material layer, and a second doped silicon oxide layer are prepared on the structure shown in FIG. 4.
FIG. 6 is a schematic view of the structure after a conductive block is formed on the structure shown in FIG. 5.

### Reference Numerals:

100, back-contact solar cell; 101, silicon substrate; 102, first doped silicon layer; 103, second doped silicon layer; 104, conductive block; 105, first tunneling layer; 106, second tunneling layer; 107, passivation layer; 108, protective layer; 109, first electrode; 110, second electrode; 200, isolation region; 1041, third doped silicon layer; 1042, third tunneling layer; 1043, isolation buffer layer; 1051, first tunneling material layer; 1021, first doped silicon material layer; 112, first doped silicon oxide layer; 113, second doped silicon oxide layer; 1031, second doped silicon material layer; 1061, second tunneling material layer.

### DETAILED DESCRIPTION

In order to make the above objectives, features and advantages of the present invention more obvious and understandable, specific embodiments of the present invention are described in detail below. In the following description, many specific details are set forth in order to fully understand the present invention. However, the present invention can be implemented in many other ways different from those described herein, and those skilled in the art can make similar improvements without departing from the connotation of the present invention. Therefore, the present invention is not limited by the specific embodiments disclosed below.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one of the features. In the description of the present invention, "plurality" means at least two, such as two, three, etc., unless otherwise specifically defined.

In the present invention, the terms "mounting," "connecting together," "connecting," "fixing" and the like should be understood broadly. For example, it could be understood as a fixed connection, a detachable connection, or an integrated connection; it could be understood as a mechanical connection or an electrical connection; it could be understood as a direct connection or an indirect connection by an intermediate medium; and it could be understood as an internal communication between two elements or an interaction between two elements, unless otherwise expressly defined. For those skilled in the art, the specific meaning of the aforementioned terms in the present invention can be understood according to specific situations.

All technical and scientific terms used herein have the same meaning as commonly understood by those of ordinary skill in the art to which the present invention applies, unless otherwise defined. The terms used in the specification of the present invention herein are for the purpose of describing specific embodiments only and are not intended to limit the present invention. The term "and/or" used herein includes any and all combinations of one or more of the associated listed items.

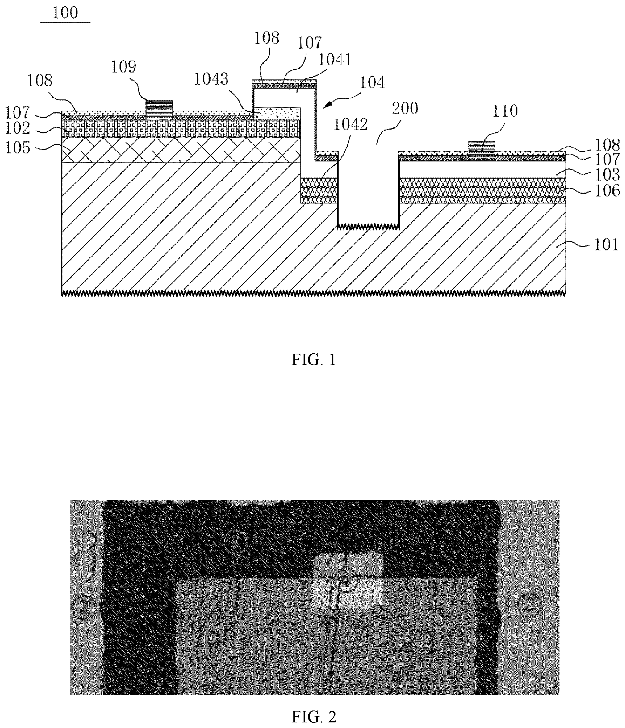

Referring to FIGS. 1 and 2, a back-contact solar cell 100 is provided according to an embodiment of the present invention. The back-contact solar cell 100 includes a silicon substrate 101, a first doped silicon layer 102, a second doped silicon layer 103, and a conductive block 104.

The first doped silicon layer 102 and the second doped silicon layer 103 are provided on a back side of the silicon substrate 101, and the first doped silicon layer 102 and the second doped silicon layer 103 have opposite doping types and are separated by an isolation region 200. The conductive block 104 is provided on the back side of the silicon substrate 101, and the conductive block 104 is partially located on the first doped silicon layer 102 and is partially located in the isolation region 200. The conductive block 104 includes a third doped silicon layer 1041 having the same doping type as the second doped silicon layer 103 and the silicon substrate 101. The first doped silicon layer 102 and the third doped silicon layer 1041 are in electrical contact via an isolation buffer layer 1043. A doping concentration of an N-type doping element in the third doped silicon layer 1041 is greater than a doping concentration of an N-type doping element in the silicon substrate 101.

In the aforementioned back-contact solar cell 100, the concentration of the N-type doping element in the third doped silicon layer 1041 is greater than the concentration of the N-type doping element in the silicon substrate 101, such that the third doped silicon layer 1041 with a higher concentration of N-type doping element is in electrical contact with the silicon substrate 101 with a lower concentration of N-type doping element. Due to the difference in doping concentration, a built-in electric field is generated, which leads to the formation of a potential barrier height difference, such that when the cell is in normal operation, there is no conduction among the silicon substrate 101, the third doped silicon layer 1041, and the first doped silicon layer 102. However, this built-in electric field is relatively weak. When the back-contact solar module is in a reverse bias state, electrons in the low-doped silicon substrate 101 can easily drift to the highly-doped third doped silicon layer 1041 under the action of the reverse bias voltage. Therefore, the structure can form a current through drift motion under an external reverse bias. Since the conductive block 104 and the second doped silicon layer 103 have the same doping type, when the cell is in the reverse bias state, the silicon substrate 101, the third doped silicon layer 1041, and the first doped silicon layer 102 can form an effective current channel.

In this way, when the back-contact solar cell 100 is in abnormal operation such as being shaded and a reverse bias is generated, photogenerated electrons flowing to the second doped silicon layer 103 and photogenerated holes flowing to the first doped silicon layer 102 construct a leakage path through a third tunneling layer 1042 and the third doped silicon layer 1041 in the conductive block 104, which can effectively reduce the risk of hot spots in the back-contact solar cell 100.

In addition, the conductive block 104 is partially provided on the first doped silicon layer 102 and partially in the isolation region 200. Compared with the instance where the conductive block 104 is entirely provided on the first doped silicon layer 102, when the conductive block 104 is provided on the first doped silicon layer 102 and on the isolation region 200 simultaneously, a leakage path with a reasonable annihilation efficiency of photogenerated electrons and photogenerated holes is formed between the positive current formed by the photogenerated holes flowing to the first doped silicon layer 102 and the negative current formed by the photogenerated electrons flowing to the third doped silicon layer 1041, which is beneficial to improving the annihilation efficiency of photogenerated electrons and photogenerated holes in the corresponding region of the conductive block 104 when a hot spot effect occurs in the back-contact solar module, thereby improving the anti-hot-spot effect of the back-contact solar module.

It should be noted that "doping type" includes N-type and P-type. Opposite doping types of two doped silicon layers means that one of the doped silicon layers is an N-type doped silicon layer and the other doped silicon layer is a P-type doped silicon layer. The same doping type of two doped silicon layers means that both doped silicon layers are N-type doped silicon layers, or both are P-type doped silicon layers. Doping elements of N-type doping include phosphorus (P), arsenic (As), antimony (Sb) and other elements; and doping elements of P-type doping include boron (B), aluminum (Al), indium (In) and other elements.

In FIG. 2, the portion indicated by label ① is the area where the first doped silicon layer 102 is located, the portion indicated by label ② on the periphery thereof is the area where the second doped silicon layer 103 is located, the portion indicated by label ③ in the black area between the two is the isolation region 200, and the portion indicated by label ④ which partially overlaps with the area where the first doped silicon layer 102 is located and the isolation region 200 is the area where the conductive block 104 is located.

In some embodiments, along a thickness direction of the silicon substrate 101, a ratio of an orthographic projection area of the conductive block 104 located on the first doped silicon layer 102 to an orthographic projection area of the conductive block 104 located in the isolation region 200 is in a range of 0.1 to 10. In this way, by controlling the ratio of the area of the conductive block 104 located on the first doped silicon layer 102 to the area of the conductive block 104 located in the isolation region 200 within the aforementioned range, not only the hot spot phenomenon can be alleviated through a leakage path formed between the silicon substrate 101, the third doped silicon layer 1041, and the first doped silicon layer 102 when the cell is reverse biased, but also the adverse effects of the conductive block 104 on the first doped silicon layer 102 can be reduced. When the ratio of the orthographic projection area of the conductive block 104 located on the first doped silicon layer 102 to the orthographic projection area of the conductive block 104 located in the isolation region 200 is less than 0.1, the positive current density formed by the photogenerated holes flowing to the first doped silicon layer 102 is much less than the negative current density formed by the photogenerated electrons flowing to the third doped silicon layer 1041, which cannot provide the maximum leakage path, weakens the annihilation efficiency of the photogenerated electrons and photogenerated holes in the corresponding area of the conductive block 104, which is not conducive to improving the anti-hot-spot effect of the back-contact solar module when reverse bias occurs. Similarly, when the ratio of the orthographic projection area of the conductive block 104 located on the first doped silicon layer 102 to the orthographic projection area of the conductive block 104 located in the isolation region 200 is greater than 10, the positive current density formed by the photogenerated holes flowing to the first doped silicon layer 102 is much greater than the negative current density formed by the photogenerated electrons flowing to the third doped silicon layer 1041, which cannot provide the maximum leakage path, weakens the annihilation efficiency of the photogenerated electrons and photogenerated holes in the corresponding area of the conductive block 104, being not conducive to improving the anti-hot-spot effect of the back-contact solar module when reverse bias occurs.

It can be understood that the ratio of the orthographic projection area of the conductive block 104 located on the first doped silicon layer 102 to the orthographic projection area of the conductive block 104 located in the isolation region 200 may be 0.1, 0.2, 0.3, 0.4, 0.5, 0.6, 0.7, 0.8, 0.9, 1, 2, 3, 4, 5, 6, 7, 8, 9, 10, and any ratio within the range formed by any two of the aforementioned ratios.

In some embodiments, the doping concentration of the doping element in the third doped silicon layer 1041 is in a range of 1×10¹⁹/cm³ to 1×10²¹/cm³. The doping concentration of the doping element in the silicon substrate 101 is in a range of 1×10¹³/cm³ to 1×10¹⁶/cm³. In this way, the third doped silicon layer 1041 has a higher concentration of the doping element, and the silicon substrate 101 has a relatively lower concentration of the doping element, a potential barrier height difference is formed between the third doped silicon layer 1041 and the silicon substrate 101, which is beneficial to reducing the transition barrier of photogenerated electrons, and further beneficial to improving the tunneling collection efficiency of photogenerated electrons.

It can be understood that the doping concentration of the doping element in the third doped silicon layer 1041 may be 1×10¹⁹/cm³, 2×10¹⁹/cm³, 5×10¹⁹/m³, 1×10²⁰/m³, 5×10²⁰/cm³, 1×10²¹/cm³, and any numerical value within the range formed by any two of the aforementioned numerical values. The doping concentration of the doping element in the silicon substrate 101 may be 1×10¹³/cm³, 5×10¹³/cm³, 1×10¹⁴/cm³, 5×10¹⁴/cm³, 1×10¹⁵/cm³, 5×10¹⁵/cm³, 1×10¹⁶/cm³, and any numerical value within the range formed by any two of the aforementioned numerical values.

In some embodiments, a thickness of the third doped silicon layer 1041 is in a range of 10 nm to 400 nm. It should be noted that the thickness of the third doped silicon layer 1041 refers to the thickness of the portion of the third doped silicon layer 1041 located on the first doped silicon layer 102, or the portion located in the isolation region 200. It can be understood that the thickness of the third doped silicon layer 1041 may be 10 nm, 20 nm, 30 nm, 40 nm, 50 nm, 60 nm, 70 nm, 80 nm, 90 nm, 100 nm, 120 nm, 150 nm, 180 nm, 200 nm, 220 nm, 250 nm, 280 nm, 300 nm, 320 nm, 350 nm, 380 nm, 400 nm and any numerical value within the range formed by any two of the aforementioned numerical values.

In some embodiments, the conductive block 104 further includes a third tunneling layer 1042. The third tunneling layer 1042 is provided in the isolation region 200 and is located between the silicon substrate 101 and the third doped silicon layer 1041. Furthermore, the third tunneling layer 1042 may be made of silicon dioxide, silicon nitride, silicon carbide or the like. A thickness of the third tunneling layer 1042 is less than or equal to 3 nm.

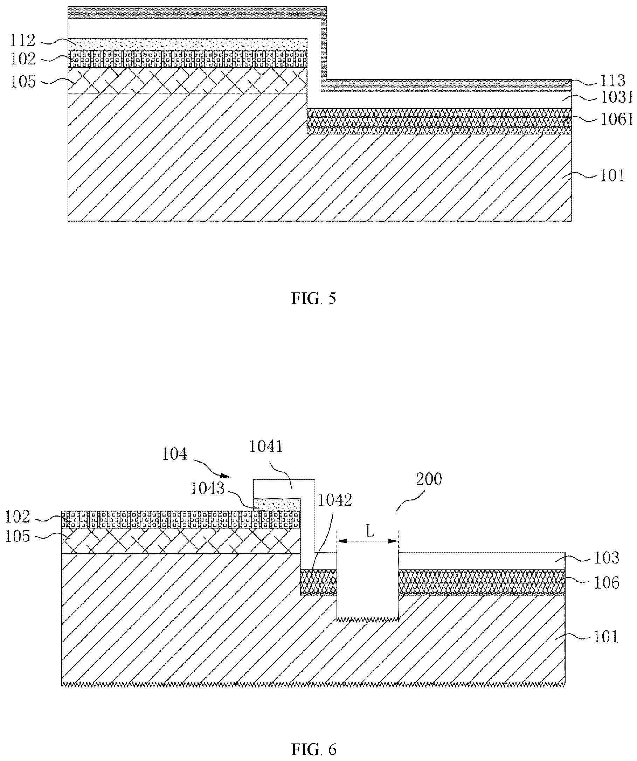

In some embodiments, referring to FIG. 6, a spacing L between the conductive block 104 and the second doped silicon layer 103 is in a range of 10 µm to 300 µm. In this way, an edge of the conductive block 104 has an appropriate distance from the second doped silicon layer 103, ensuring that the conductive block 104 does not directly contact the second doped silicon layer 103. The formation of leakage conduction requires both positive photogenerated holes and negative photogenerated electrons. On the one hand, when the spacing between the conductive block 104 and the second doped silicon layer 103 is too large, that is, when the spacing is greater than 300 µm, it means that the area of the conduction block 104 located in the isolation region 200 accounts for a relatively small proportion, indicating that the leakage area corresponding to the leakage current path providing negative photogenerated electrons is also relatively small, which is not conducive to improving the annihilation efficiency of photogenerated electrons and photogenerated holes in the corresponding area of the conduction block 104 under reverse bias. On the other hand, when the spacing between the conductive block 104 and the second doped silicon layer 103 is too small, for example, less than 10 µm, it means that the area of the corresponding third doped silicon layer 1041 in the conductive block 104 accounts for a relatively small proportion, indicating that the leakage area corresponding to the leakage current path providing positive photogenerated holes is also relatively small, which is not conducive to improving the annihilation efficiency of photogenerated electrons and photogenerated holes in the corresponding area of the conduction block 104 under reverse bias. It can be understood that the spacing between the conductive block 104 and the second doped silicon layer 103 may be 10 µm, 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, 200 µm, 210 µm, 220 µm, 230 µm, 240 µm, 250 µm, 260 µm, 270 µm, 280 µm, 290 µm, 300 µm, and any numerical value within the range formed by any two of the aforementioned numerical values.

In some embodiments, along the thickness direction of the silicon substrate 101, an orthographic projection area of the conductive block 104 is in a range of 1×10²µm² to 1×10⁵µm². If the area of the conductive block 104 is too small, the conductive area of the photogenerated electrons and photogenerated holes in the corresponding area of the conductive block 104 under reverse bias will be reduced, thereby reducing the annihilation efficiency of the photogenerated electrons and photogenerated holes, which is not conducive to improving the anti-hot-spot effect under reverse bias. If the area of the conductive block 104 is too large, too many recombination areas of photogenerated electrons and photogenerated holes will be formed, increasing the leakage current flow path of the back-contact cell in normal operation, which is not conducive to improving the conversion efficiency of the back-contact solar cell in normal operation. By controlling the orthographic projection area of the conductive block 104 along the thickness direction of the silicon substrate 101 within the aforementioned range, not only can the anti-hot-spot effect under reverse bias be effectively improved, but it is also beneficial to ensuring the conversion efficiency of the back-contact cell in normal operation.

It can be understood that, along the thickness direction of the silicon substrate 101, the orthographic projection area of the conductive block 104 may be 1×10²µm², 5×10²µm², 1×10³µm², 5×10³µm², 1×10⁴µm², 5×10⁴µm², 1×10⁵µm², and any numerical value within the range formed by any two of the aforementioned numerical values. It should be noted that the shape of the conductive block 104 may be square, rectangular, diamond, triangle, circle, ellipse, trapezoid, etc., or other irregular shapes.

In some embodiments, a plurality of conductive blocks 104 are provided. Along the thickness direction of the silicon substrate 101, a sum of orthographic projection areas of the plurality of conductive blocks 104 accounts for 0.01% to 1.8% of an orthographic projection area of the silicon substrate 101. In this way, when the cell is reverse biased, a leakage path can be effectively formed between the conductive block 104, the silicon substrate 101, and the second doped silicon layer 103, thereby effectively alleviating the hot spot phenomenon, while having a relatively small impact on the output power of the cell.

It can be understood that the ratio of the sum of orthographic projection areas of the plurality of conductive blocks 104 to the orthographic projection area of the silicon substrate 101 may be 0.01%, 0.05%, 0.08%, 0.1%, 0.2%, 0.4%, 0.5%, 0.6%, 0.8%, 0.9%, 1%, 1.1%, 1.2%, 1.3%, 1.4%, 1.5%, 1.6%, 1.7%, 1.8%, and any numerical value within the range formed by any two of the aforementioned numerical values.

Furthermore, the plurality of conductive blocks 104 may be arranged on one first doped silicon layer 102 or a plurality of different first doped silicon layers 102. In one embodiment, the plurality of conductive blocks 104 are arranged on the plurality of different first doped silicon layers 102. The plurality of conductive blocks 104 may be provided on each adjacent first doped silicon layer 102, or may be provided so that one conductive block 104 is included every one, two, three or more first doped silicon layers 102. The conductive blocks 104 on different first doped silicon layers 102 may be arranged at positions corresponding to each other or staggered from each other.

In some embodiment, thicknesses of the first doped silicon layer 102 and the second doped silicon layer 103 are independently in a range of 10 nm to 400 nm. A ratio of a doping concentration of a doping element in the first doped silicon layer 102 to a doping concentration of a doping element in the second doped silicon layer 103 is in a range of 6% to 70%.

It can be understood that thicknesses of the first doped silicon layer 102 and the second doped silicon layer 103 may independently be 10 nm, 20 nm, 30 nm, 40 nm, 50 nm, 60 nm, 70 nm, 80 nm, 90 nm, 100 nm, 120 nm, 150 nm, 180 nm, 200 nm, 220 nm, 250 nm, 280 nm, 300 nm, 320 nm, 350 nm, 380 nm, 400 nm and any numerical value within the range formed by any two of the aforementioned numerical values. The ratio of the doping concentration of the doping element in the first doped silicon layer 102 to the doping concentration of the doping element in the second doped silicon layer 103 may be 6%, 10%, 15%, 20%, 25%, 30%, 35%, 40%, 45%, 50%, 55%, 60%, 65%, 70%, and any numerical value within the range formed by any two of the aforementioned numerical values.

Furthermore, the first doped silicon layer 102, the second doped silicon layer 103, and the third doped silicon layer 1041 may each independently be a polycrystalline silicon layer or an amorphous silicon layer.

In some embodiments, the back-contact solar cell 100 further includes a first tunneling layer 105 and a second tunneling layer 106. The first tunneling layer 105 is located between the first doped silicon layer 102 and the silicon substrate 101. The second tunneling layer 106 is located between the second doped silicon layer 103 and the silicon substrate 101. Furthermore, the first tunneling layer 105 and the second tunneling layer 106 can be independently made of silicon oxide, amorphous silicon, hydrogenated amorphous silicon, hydrogenated microcrystalline silicon, silicon nitride, and silicon carbide. Thicknesses of the first tunneling layer 105 and the second tunneling layer 106 may be independently less than or equal to 3 nm.

In some embodiments, the isolation buffer layer 1043 is provided on a side of the first doped silicon layer 102 away from the silicon substrate 101, and is located between the third doped silicon layer 1041 and the first doped silicon layer 102. In this way, by providing the aforementioned isolation buffer layer 1043, it is beneficial to avoiding large-area direct physical contact between the third doped silicon layer 1041 and the first doped silicon layer 102.

Specifically, the isolation buffer layer 1043 is made of silicon oxide doped with boron and/or phosphorus.

In some embodiments, referring to FIG. 1, a passivation layer 107 is further provided on the back side of the silicon substrate 101, on the first doped silicon layer 102, the second doped silicon layer 103, and the third doped silicon layer 1041, as well as in the isolation region 200, and a protective layer 108 is further provided on the passivation layer 107. The passivation layer 107 may be made of aluminum oxide, and the protective layer 108 may be made of silicon nitride, silicon oxide, silicon oxynitride, etc. By providing the aforementioned passivation layer 107 and protective layer 108, a passivation effect can be achieved, as well as a function of protecting the internal structure of the cell.

Furthermore, the aforementioned passivation layer 107 is also provided on the front side of the silicon substrate 101, and the aforementioned protective layer 108 is also provided on the passivation layer 107.

In some specific embodiments, a thickness of the passivation layer 107 on the front and back sides of the silicon substrate 101 may independently be 10 nm, 20 nm, 30 nm, 40 nm, 50 nm, 60 nm, 70 nm, 80 nm, 90 nm, 100 nm, 110 nm, 120 nm, 130 nm, 140 nm, 150 nm, and any numerical value within the range formed by any two of the aforementioned numerical values.

In some embodiments, a first electrode 109 is provided on the protective layer 108 corresponding to the first doped silicon layer 102 on the back side of the silicon substrate 101, and the first electrode 109 extends through the passivation layer 107 and the protective layer 108 and is in contact with the first doped silicon layer 102. A second electrode 110 is provided on the protective layer 108 corresponding to the second doped silicon layer 103 on the back side of the silicon substrate 101, and the second electrode 110 extends through the passivation layer 107 and the protective layer 108 and is in contact with the second doped silicon layer 103. Furthermore, the first electrode 109 and the second electrode 110 are made of a material with good electrical conductivity, such as silver, copper, etc.

A method for preparing the aforementioned back-contact solar cell 100 is provided according to an embodiment of the present invention, the method includes the following steps. A first doped silicon layer 102, a second doped silicon layer 103, and a conductive block 104 are formed on a back side of a silicon substrate 101. The first doped silicon layer 102 and the second doped silicon layer 103 have opposite doping types and are separated by an isolation region 200. The conductive block 104 is partially located on the first doped silicon layer 102 and partially located in the isolation region 200. The conductive block 104 includes a third doped silicon layer 1041 having the same doping type as the second doped silicon layer 103 and the silicon substrate 101. The first doped silicon layer 102 and the third doped silicon layer 1041 are in electrical contact via an isolation buffer layer 1043. A doping concentration of a doping element in the third doped silicon layer 1041 is greater than a doping concentration of a doping element in the silicon substrate 101.

According to the aforementioned method for preparing the back-contact solar cell 100, when a reverse bias is generated due to abnormal operation of the back-contact solar cell 100 such as being shaded, a current flow path can be formed among the silicon substrate 101, the third doped silicon layer 1041, and the first doped silicon layer 102, thereby effectively reducing the risk of hot spots in the back-contact solar cell 100. In addition, by providing a part of the conductive block 104 on the first doped silicon layer 102 and a part in the isolation region 200, compared with the instance where the conductive block 104 is entirely provided on the first doped silicon layer 102, a balance can be achieved between the conductive contact area representing the positive current flowing to the first doped silicon layer 102 and conductive contact area representing the negative current flowing to the third doped silicon layer 1041, thereby achieving the maximum annihilation efficiency between the positive photogenerated holes and the negative photogenerated electrons, which is beneficial to improving the anti-hot-spot effect of the back-contact solar module when reverse bias occurs.

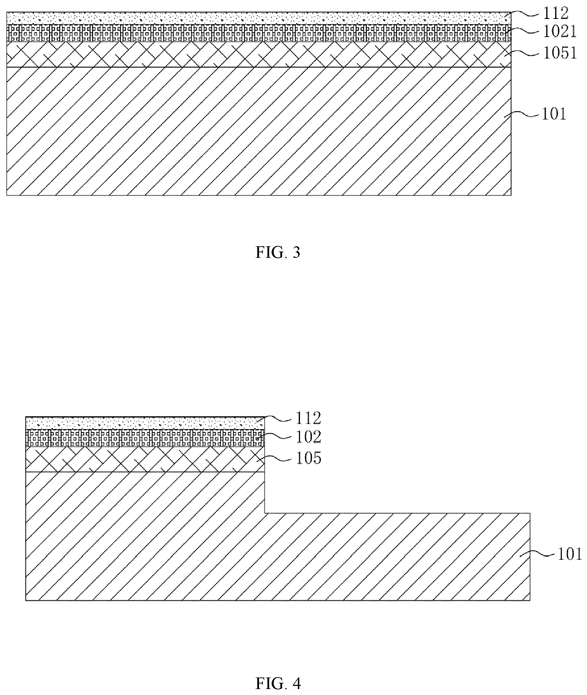

In some embodiments, the first doped silicon layer 102 is formed on the back side of the silicon substrate 101 by the following steps. Referring to FIG. 3, a first tunneling material layer 1051, a first doped silicon material layer 1021, and a first doped silicon oxide layer 112 are sequentially formed on the back side of the silicon substrate 101. Referring to FIG. 4, the first doped silicon oxide layer 112, the first doped silicon material layer 1021, the first tunneling material layer 1051 within the second doped silicon layer 103, the isolation region 200, and the conductive block 104 as well as a part of the silicon substrate material are removed. The first doped silicon oxide layer 112 retained on the back side of the silicon substrate 101 serves as a mask, the retained first doped silicon material layer 1021 is used as the first doped silicon layer 102, and the retained first tunneling material layer 1051 is used as the first tunneling layer 105.

In some specific embodiments, the first tunneling material layer 1051 made of silicon oxide is deposited on the back side of a polished silicon substrate 101 by low-pressure chemical vapor deposition (LPCVD) or plasma-enhanced chemical vapor deposition (PECVD). An amorphous silicon layer is then grown on the first tunneling material layer 1051. A doping element is doped into the amorphous silicon layer through a diffusion process to form a first doped silicon material layer 1021, and the surface of the first doped silicon material layer 1021 is oxidized to form the first doped silicon oxide layer 112. The first doped silicon oxide layer 112 may serve as a mask layer for subsequent etching to protect the first doped silicon material layer 1021 thereunder from being etched by chemical reagents.

In some specific embodiments, a picosecond or femtosecond laser with a wavelength of 200 nm to 1300 nm and a power of 20 W to 200 W is used to process the film layer on the back side of the silicon substrate 101 in the area where the second doped silicon layer 103, the isolation region 200 and the conductive block 104 are located. Then, an alkaline liquid such as NaOH or KOH with a mass fraction of 5% to 30% is used to etch the silicon substrate 101 at a temperature of 70°C to 90°C for 1 min to 10 min, so as to remove the first doped silicon oxide layer 112, the first doped silicon material layer 1021 and the first tunneling material layer 1051 in the laser-treated area. The silicon substrate 101 in this area is etched to form a groove.

In some embodiments, a second doped silicon layer 103 and a conductive block 104 are formed on the back side of the silicon substrate 101 by the following steps. Referring to FIG. 5, a second doped silicon material layer 1031 is formed on the back side of the silicon substrate 101 after forming the first tunneling layer 105 and the first doped silicon layer 102. Referring to FIG. 6, the second doped silicon material layer 1031 outside the second doped silicon layer 103 and the conductive block 104 are removed, and the retained second doped silicon material layer 1031 on the back side of the silicon substrate 101 serves as the second doped silicon layer 103 and the third doped silicon layer 1041.

Referring to FIG. 5, in some specific embodiments, a second tunneling material layer 1061 made of silicon dioxide is deposited on the back side of the silicon substrate 101by LPCVD or PECVD method. Then an amorphous silicon layer is grown on the second tunneling material layer 1061. And then, a doping element is doped into the amorphous silicon layer through a diffusion process to form a second doped silicon material layer 1031, and the surface of the second doped silicon material layer 1031 is oxidized to form the second doped silicon oxide layer 113. The second doped silicon oxide layer 113 may serve as a mask layer for subsequent etching to protect the second doped silicon material layer 1031 thereunder from being etched by chemical reagents.

In some specific examples, laser is used to process the film layer on the back side of the silicon substrate 101 outside the second doped silicon layer 103 and the conductive block 104. Then the silicon substrate 101 is etched with an alkaline liquid such as NaOH and KOH to remove the second doped silicon oxide layer 113, the second doped silicon material layer 1031, and the second tunneling material layer 1061 within the laser-treated area. The silicon substrate 101 in the area is etched to form a groove, and a pyramidal textured structure is formed inside the groove. HF is used to remove the remaining first doped silicon oxide layer 112 and the second doped silicon oxide layer 113. It should be noted that, in this step, the light-receiving side (front side) of the silicon substrate 101 will also be prepared into a textured structure.

In some embodiments, after forming the second doped silicon layer 103 and the conductive block 104 on the back side of the silicon substrate 101, the method further includes the following steps. A passivation layer 107 is prepared on the front and back sides of the silicon substrate 101, respectively. A protective layer 108 is prepared on the passivation layer 107 on the front and back sides of the silicon substrate 101, respectively. A first electrode 109 is prepared on the protective layer 108 corresponding to the first doped silicon layer 102, and the first electrode 109 passes through the protective layer 108 and the passivation layer 107 and comes into contact the first doped silicon layer 102. A second electrode 110 is prepared on the protective layer 108 corresponding to the second doped silicon layer 103, and the second electrode 110 passes through the protective layer 108 and the passivation layer 107 and comes into contact the second doped silicon layer 103. The final structure of the back-contact solar cell 100 is shown in FIG. 1.

Specifically, the passivation layer 107 may be formed on the front side and the back side of the silicon substrate 101 by using an ALD atomic layer deposition method. The passivation layer 107 may be made of aluminum oxide, hafnium oxide, titanium oxide, etc. The protective layer 108 may be formed on the passivation layer 107 on the front and back sides of the silicon substrate 101 by using a PECVD method. The protective layer 108 may be made of one or more of silicon nitride, silicon carbide, silicon oxide, and silicon oxynitride.

A back-contact solar module (not shown) is provided according to an embodiment of the present disclose. The back-contact solar module includes one or more of the back-contact solar cells 100 described above in the present invention, or the back-contact solar cells 100 prepared by the method for preparing the back-contact solar cell 100 described above in the present invention. The aforementioned back-contact solar module can effectively alleviate the occurrence of hot spot phenomenon by adopting the aforementioned back-contact solar cell 100 in the present invention or by adopting the back-contact solar cell 100 prepared by the aforementioned method in the present invention.

## Claims

1. A back-contact solar cell (100), comprising:
a silicon substrate (101);
a first doped silicon layer (102) and a second doped silicon layer (103) that are provided on a back side of the silicon substrate (101), the first doped silicon layer (102) and the second doped silicon layer (103) having opposite doping types and being separated by an isolation region (200); and
a conductive block (104) provided on the back side of the silicon substrate (101), partially located on the first doped silicon layer (102) and partially located in the isolation region (200); the conductive block (104) comprising a third doped silicon layer (1041) having a same doping type as the second doped silicon layer (103) and the silicon substrate (101);
wherein the first doped silicon layer (102) and the third doped silicon layer (1041) are in electrical contact via an isolation buffer layer (1043), and a doping concentration of a doping element in the third doped silicon layer (1041) is greater than a doping concentration of a doping element in the silicon substrate (101).

2. The back-contact solar cell (100) according to claim 1, wherein along a thickness direction of the silicon substrate (101), a ratio of an orthographic projection area of a portion of the conductive block (104) located on the first doped silicon layer (102) to an orthographic projection area of a portion of the conductive block (104) located in the isolation region (200) is in a range of 0.1 to 10.

3. The back-contact solar cell (100) according to claim 1 or 2, wherein the doping concentration of the doping element in the third doped silicon layer (1041) is in a range of 1×10¹⁹/cm³ to 1×10²¹/cm³; and/or
the doping concentration of the doping element in the silicon substrate (101) is in a range of 1×10¹³/cm³ to 1×10¹⁶/cm³.

4. The back-contact solar cell (100) according to claim 1 or 2, wherein a thickness of the third doped silicon layer (1041) is in a range of 10 nm to 400 nm.

5. The back-contact solar cell (100) according to claim 1 or 2, wherein a spacing between the conductive block (104) and the second doped silicon layer (103) is in a range of 10 µm to 300 µm.

6. The back-contact solar cell (100) according to claim 1 or 2, wherein along a thickness direction of the silicon substrate (101), an orthographic projection area of the conductive block (104) is in a range of 1×10² µm² to 1×10⁵ µm².

7. The back-contact solar cell (100) according to claim 1 or 2, wherein a plurality of conductive blocks (104) are provided, and along a thickness direction of the silicon substrate (101), a sum of orthographic projection areas of the plurality of conductive blocks (104) accounts for 0.01% to 1.8% of an orthographic projection area of the silicon substrate (101).

8. The back-contact solar cell (100) according to claim 1 or 2, wherein thicknesses of the first doped silicon layer (102) and the second doped silicon layer (103) are independently in a range of 10 nm to 400 nm.

9. The back-contact solar cell (100) according to claim 1 or 2, wherein a ratio of a doping concentration of a doping element in the first doped silicon layer (102) to a doping concentration of a doping element in the second doped silicon layer (103) is in a range of 6% to 70%.

10. The back-contact solar cell (100) according to claim 1 or 2, further comprising a first tunneling layer (105) located between the first doped silicon layer (102) and the silicon substrate (101).

11. The back-contact solar cell (100) according to claim 10, further comprising a second tunneling layer (106) located between the second doped silicon layer (103) and the silicon substrate (101).

12. The back-contact solar cell (100) according to claim 11, wherein the conductive block (104) further comprises a third tunneling layer (1042) provided in the isolation region (200) and located between the silicon substrate (101) and the third doped silicon layer (1041).

13. The back-contact solar cell (100) according to claim 1 or 2, wherein the isolation buffer layer (1043) is provided on a side of the first doped silicon layer (102) away from the silicon substrate (101), and is located between the third doped silicon layer (1041) and the first doped silicon layer (102).

14. The back-contact solar cell (100) according to claim 1 or 2, wherein the isolation buffer layer (1043) is made of silicon oxide doped with at least one of boron and phosphorus.

15. Aback-contact solar module, comprising the back-contact solar cell (100) according to any one of claims 1 to 14.
